# EUROPÄISCHE PATENTANMELDUNG

(11) **EP 1 063 678 A2**
(43) Veröffentlichungstag der Anmeldung: **27.12.2000**
(21) Anmeldenummer: 00112949.3
(22) Anmeldetag: 20.06.2000
(51) Int. Cl.: H01J 37/32

(54) **Vorrichtung zur Erzeugung eines Plasmas in einer Kammer durch Mikrowellenanregung**

(30) Priorität: 24.06.1999 DE 19928876
(71) Anmelder: Leybold Systems GmbH, 63450 Hanau (DE)
(72) Erfinder: Beckmann, Rudolf, 63454 Hanau (DE); Schulte, Thomas, 49779 Niederlangen (DE); Naumann, Thorsten, 63829 Krombach (DE); Grünwald, Heinrich, 61194 Niddatal (DE)
(74) Vertreter: Schickedanz, Willi, Dipl.-Ing.

(57) **Zusammenfassung**

Die Erfindung betrifft eine Vorrichtung zur Erzeugung eines Plasmas durch Mikrowellenanregung. Hierbei wird zwischen wenigstens zwei Mikrowellenstrahlern (8, 9), die sich im Plasmaraum befinden, eine Sperre aus elektrisch leitendem Material vorgesehen. Durch diese Sperre wird verhindert, dass sich die Mikrowellen der beiden Mikrowellenstrahler (8, 9) gegenseitig beeinflussen und somit ein beachtlicher Teil der elektrischen Leistung der Mikrowellenstrahler (8, 9) nicht in die Erzeugung von Plasma umgesetzt werden kann.

## Beschreibung

Die Erfindung betrifft eine Vorrichtung nach dem Oberbegriff des Patentanspruchs 1.

Plasmen sind ionisierte Gase, deren Atome zumindest teilweise eines oder mehrere Elektronen verloren und sich in positive Ionen verwandelt haben. Solche Plasmen werden beispielsweise für die Beschichtung, Härtung oder sonstige Bearbeitung von Materialien verwendet.

In der Regel erfolgt die Erzeugung solcher Plasmen in Unterdruckbehältern mit Hilfe geeigneter Anregungsmittel.

Als Anregungsmittel kommen hauptsächlich elektromagnetische Wellen in Frage, unter denen wieder die Mikrowellen eine bevorzugte Stellung einnehmen. Unter Mikrowellen versteht man elektromagnetische Wellen, deren Wellenlängen sich vom Millimeter- bis Dezimeterbereich erstrecken.

Es ist bereits eine Vorrichtung für die Erzeugung eines Plasmas durch Mikrowellen bekannt, bei welcher die Mikrowellen über einen Hohlleiter und durch eine Glashaube in einen Plasmaraum gelangen, der sich über einem Substratteller befindet (DE 40 34 450 A1, Fig. 8). Hierbei ist nur eine einzige in das Plasma einstrahlende Mikrowellenvorrichtung vorgesehen.

Eine andere Art der Einkopplung von Mikrowellen in ein Plasma ist in der DE 41 36 297 A1 beschrieben. Hierbei besitzt die Mikrowellen-Einkoppeleinrichtung einen Innenleiter aus Metall, auf den Mikrowellen eingekoppelt werden. Dieser Innenleiter ist von einem Führungshohlleiter aus isolierendem Material umgeben. Als besonders vorteilhaft wird dabei der Einsatz von drei solchen Einkoppel-Vorrichtungen in einer Plasma-Behandlungskammer angesehen. Diese Einkopplungs-Vorrichtungen liegen dabei unmittelbar einander gegenüber.

Bei einer weiteren Vorrichtung zur Erzeugung von Plasma in einem Unterdruckbehälter ist es bekannt, einen stabförmigen Leiter innerhalb eines Rohres aus isolierendem Werkstoff durch diesen Unterdruckbehälter zu führen (DE 195 03 205 C1, DE 196 28 949 A1). Dabei ist der stabförmige Leiter an beiden Enden an Quellen zur Erzeugung der elektromagnetischen Wechselfelder angeschlossen.

Eine ähnliche Vorrichtung ist auch aus der DE 196 28 954 A1 bekannt, wobei jedoch der Raum zwischen dem stabförmigen Leiter und dem Rohr mit einem festen Dielektrikum ausgefüllt ist.

Nachteilig ist bei diesen bekannten Vorrichtungen, dass dann, wenn mehrere Mikrowellen ausstrahlende Antennen nebeneinander angeordnet sind, ein Großteil der Mikrowellenleistung nicht zum Erzeugen von Plasma dient, sondern zu den Mikrowellensendern zurückläuft. Um Beschädigungen der Mikrowellenerzeuger zu vermeiden, müssen hierbei teure Zirkulatoren eingesetzt werden. Eine Ausbildung von homogenen Plasmafeldern ist unter diesen Umständen nur unzureichend möglich.

Der Erfindung liegt deshalb die Aufgabe zugrunde, den Anteil der für die Erzeugung eines Plasmas umgesetzten Mikrowellenleistung, die von benachbarten Sendern oder Antennen ausgestrahlt wird, zu erhöhen.

Diese Aufgabe wird gemäß den Merkmalen des Patentanspruchs 1 gelöst.

Die Erfindung betrifft somit eine Vorrichtung zur Erzeugung eines Plasmas durch Mikrowellenanregung. Hierbei wird zwischen wenigstens zwei Mikrowellenstrahlern, die sich im Plasmaraum befinden, eine Sperre aus elektrisch leitendem Material vorgesehen. Die physikalischen Hintergründe, weshalb die Mikrowellenenergie bei Einfügung der Sperre überwiegend für die Ionisierung von Gasen verbraucht wird, sind im Einzelnen nicht bekannt. Es ist jedoch zu vermuten, dass die Sperre verhindert, dass sich die Mikrowellen der beiden Mikrowellenstrahler gegenseitig beeinflussen und somit ein beachtlicher Teil der elektrischen Leistung der Mikrowellenstrahler nicht in die Erzeugung von Plasma umgesetzt werden kann.

Der mit der Erfindung erzielte Vorteil besteht insbesondere darin, dass durch Interferenzen keine Energie mehr verloren geht, die für die Ionisierung eines Gases zum Plasma benötigt wird. Wird ohne Verwendung einer erfindungsgemäßen Zwischenwand eine elektromagnetische Leistung von beispielsweise 1 600 Watt in das Gas/Plasma eingekoppelt, so gehen mehr als 500 Watt durch Interferenzen oder Reflexionen verloren. Bei Verwendung der Zwischenwand reduziert sich die nicht für die Plasmaerzeugung effektive Leistung auf weniger als 50 Watt. Durch die Entkopplung der Mikrowellenantennen kann somit eine kleinere und damit preiswertere Mikrowellenquelle zum Einsatz kommen. Außerdem entfällt der Einbau eines Zirkulators, der bei Nichtverwendung der erfindungsgemäßen Trennwand erforderlich ist und die rücklaufende Energie von der Mikrowellenquelle fernhalten soll. Zirkulatoren sind passive, nichtreziproke Mehrtore mit mindestens drei Toren, bei denen die in ein Tor eingespeiste Leistung um eine geringe Durchgangsdämpfung geschwächt und nur an einem Tor angeboten wird, während alle anderen Tore weitgehend entkoppelt sind, wobei an ihnen nur die um eine hohe Sperrdämpfung verminderte Leistung angeboten wird.

Ausführungsbeispiele der Erfindung sind in den Zeichnungen dargestellt und werden im Folgenden näher beschrieben. Es zeigen:
- Fig. 1: einen Querschnitt durch eine Plasmakammer mit Mikrowellenanregung;
- Fig. 2: einen Längsschnitt A-A durch die in Fig. 1 dargestellte Plasmakammer;
- Fig. 3: einen Querschnitt durch eine zweite Ausführungsform einer Plasmakammer mit Mikrowellenanregung;
- Fig. 4: einen Längsschnitt durch eine dritte Ausführungsform einer Plasmakammer mit Mikrowellenanregung;
- Fig. 5: eine Abwandlung der Ausführungsform gemäß Fig. 4.

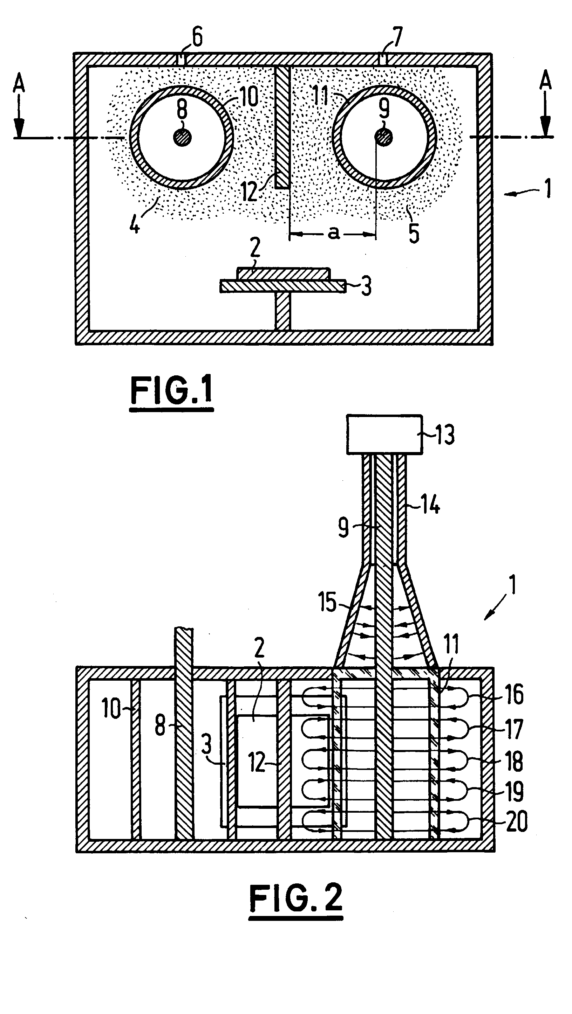

In der Fig. 1 ist ein Bearbeitungsraum 1 dargestellt, in dem ein Substrat 2, das sich auf einem Substratträger 3 befindet, mittels Plasma 4, 5 behandelt wird. Das Plasma 4, 5 wird hierbei mittels Mikrowellen aus einem Gas erzeugt, das durch Gaszuführungen 6, 7 in die Bearbeitungskammer 1 gelangt. In dieser Bearbeitungskammer 1 herrscht Unterdruck. Die Mikrowellen, welche das in die Bearbeitungskammer 1 eingetretene Gas in Plasma umwandeln, werden über elektrische leitende Stäbe 8, 9, die außerhalb der Bearbeitungskammer 1 mit Mikrowellenerzeugern verbunden sind, in die Bearbeitungskammer 1 eingeführt. Diese elektrisch leitenden Stäbe 8, 9 sind mit jeweils einem Quarzrohr 10, 11 umgeben. Aus den Stäben 8, 9 treten Mikrowellen aus, welche die Quarzrohre 10, 11 durchdringen und außerhalb der Quarzrohre das Plasma 4, 5 anregen.

Dadurch, dass die elektrisch leitenden Stäbe 8, 9 selbst nicht mit dem Plasma 4, 5 in Berührung kommen, schlägt sich auch kein Material aus dem Plasma 4, 5 auf ihnen nieder. Zwischen den Stäben 8, 9 und dem Quarzrohr herrscht Atmosphärendruck, sodass sich in diesem Raum kein Plasma ausbilden kann. Außerhalb der Quarzrohre 10, 11 herrscht jedoch Unterdruck, sodass das dort befindliche Gas durch die Mikrowellen angeregt und in Plasma umgeformt werden kann.

Zwischen den beiden benachbarten Quarzrohren 10, 11 befindet sich eine Trennwand 12 aus elektrisch leitendem Material. Diese Trennwand 12 steht senkrecht auf der Ebene, die zwischen den Stäben 8, 9 aufgespannt ist. Sie ist an einer Wand des Gehäuses 1 befestigt und ist etwa so groß wie der Durchmesser eines der Quarzrohre 10, 11. Durch diese Trennwand 12 wird vermieden, dass sich die von den beiden Stäben 8, 9 ausgehenden Mikrowellen durch Interferenz auslöschen oder auf sonstige Weise beeinflussen. Da die Mikrowellen die metallische Trennwand 12 nicht durchdringen können, sondern von dieser reflektiert werden, kann es nicht zu Überlagerungen der von den Stäben 8, 9 ausgehenden Wellen kommen. Die Trennwand 12 kann dabei auch mit Durchtrittsöffnungen versehen, d. h. als Lochblech ausgebildet sein. Auf diese Weise ist ein Gas- bzw. Plasmadurchtritt durch die Trennwand 12 möglich, was die Ausbildung homogener Plasmafelder erleichtert.

In der Regel - insbesondere wenn großflächige Substrate 2 zu bearbeiten sind - wird man mehr als zwei Quarzrohre 10, 11 nebeneinander anordnen und zwischen jeweils zwei benachbarten Rohren eine Trennwand aus elektrisch leitendem Material anordnen.

Über die Gaszuführungen 6, 7 wird ein Gas in die Kammer 1 eingeleitet, wo es durch die Mikrowellen in ein Plasma umgewandelt wird. Der Abstand a zwischen der Außenseite eines elektrisch leitenden Stabs 8, 9 und der Trennwand 12 beträgt vorzugsweise ein Viertel der Wellenlänge der von den Stäben 8, 9 ausgehenden Mikrowelle. Durch die Wahl eines λ/4-Abstands ist die Phasendifferenz zwischen der von dem Stab 9 abgestrahlten Mikrowelle und der von der leitfähigen Zwischenwand 12 reflektierten Mikrowelle genau 360 Grad, weil ein 180-Grad-Phasensprung auftritt, sodass sich beide Wellen nicht auslöschen, sondern verstärken. Hierdurch kann eine Feldüberhöhung auftreten, die ein sicheres Zündverhalten begünstigt.

Die Bearbeitungskammer 1 ist in der Regel eine Vakuumkammer, in die ein Prozessgas oder mehrere Prozessgase eingegeben werden. Mittels der Mikrowellen werden diese Prozessgase ionisiert und bilden somit ein Plasma, aus dem sich Ionen auf dem Substrat 2 niederschlagen. Hierbei wird das Substrat in vorteilhafter Weise auf negatives Potential gelegt.

Obgleich die Rohre 10, 11 vorzugsweise aus Quarz bestehen, können auch andere mikrowellendurchlässige Materialien verwendet werden, beispielsweise Keramik oder Teflon.

In der Fig. 2 ist die Bearbeitungskammer 1 noch einmal in einem Schnitt A-A dargestellt. Man erkennt hierbei wieder das Substrat 2 und den Substratträger 3 sowie die leitenden Stäbe 8, 9, die von den Quarzrohren 10, 11 umgeben sind. Außerdem ist ein Mikrowellengenerator 13 - beispielsweise ein Koaxialmagnetron - zu erkennen, der mit einem Koaxial-Hohlleiter 14 in Verbindung steht, dessen zentraler Teil eine Verlängerung des Stabs 9 darstellt. Die im Koaxial-Hohlleiter 14 verlaufende Welle wird mit Hilfe eines Trichters 15 an den leitenden Stab 9, der als Oberflächen-Wellenleiter dient, angepasst.

Die auf dem Stab 9 entstehenden Felder sind mit 16 bis 20 bezeichnet und symbolisieren Goubau-Harms'sche Oberflächenwellen.

Statt des in den Fig. 1 und 2 dargestellten stabförmigen Mikrowellenstrahlers können auch andere Strahler vorgesehen werden, wenn mit ihnen die Erzeugung eines homogenen Plasmas möglich ist.

Beispielsweise können dielektrische Rohr- oder Mantelstrahler verwendet werden, die ebenfalls zu den Oberflächenwellenantennen zählen. Auch dielektrische Stab- oder Stielstrahler oder Zweidraht-Wellenleiter kommen in Frage.

Desgleichen können auch andere nicht-abstrahlende und nur die Wellen führende Wellenleiter verwendet werden, z. B. eine geschlitzte Koaxialleitung, eine dielektrische Bildleitung oder ein Schlitzhohlleiter.

Die Quarzrohre 10, 11 stellen selbst keinen Wellenleiter dar, können jedoch mittelbar zu einer Wellenleitung führen, da direkt auf der Außenseite der Quarzrohre 10, 11 die Ionisation am stärksten ausgeprägt ist. Die stark ionisierten Plasmateilchen in unmittelbarer Nähe zur Außenseite der Quarzrohre 10, 11 können hierdurch wie ein elektrischer Leiter und damit wie der Mantel eines Koaxialkabels wirken.

In der Fig. 2 ist für einen Stab 9 ein eigener Mikrowellengenerator 13 vorgesehen. Es ist indessen auch möglich, für mehrere Stäbe nur einen Mikrowellengenerator zu verwenden, wie dies etwa in der DE 196 28 949 A1 dargestellt ist, oder Mikrowellengeneratoren auf beiden Seiten eines Stabs anzuordnen und diesen von zwei Seiten aus zu speisen.

Bei einseitiger Speisung des Stabs 9 fällt die Stärke der Mikrowellen mit zunehmender Entfernung vom Mikrowellengenerator 13 immer mehr ab. Wird nun spiegelbildlich zum Mikrowellengenerator 13 ein zweiter Mikrowellengenerator an das andere Ende des Stabs 9 angeschlossen, so kann der Intensitätsabfall der Mikrowellen kompensiert werden.

Der Abschluss eines Quarzrohrs 10, 11 bei einseitiger Einspeisung von Mikrowellen kann auf verschiedene Weise erfolgen. Zum einen kann das Quarzrohr 10, 11 an dem dem Mikrowellengenerator 13 gegenüberliegenden Ende wie ein Reagenzglas abgeschlossen sein, zum andern kann aber auch eine reflektierende Metallwand den Abschluss bilden. Bei geeigneter Größe der Quarzrohre 10, 11 und der Mikrowellen-Wellenlängen kann hierdurch eine Art Resonator gebildet werden.

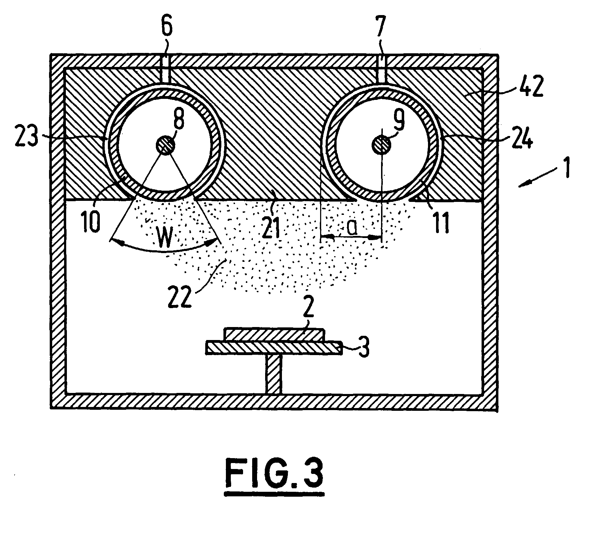

Die Fig. 3 zeigt eine Bearbeitungskammer 1, die mit den gleichen elektrisch leitenden Stäben 8, 9 und mit den gleichen Quarzrohren 10, 11 bestückt ist wie die Bearbeitungskammer 1 der Fig. 1. Die Quarzrohre 10, 11 sind bei dieser Ausführungsform jedoch in einen elektrisch leitenden Block 42 eingelassen, und zwar derart, dass dieser Block 42 nur denjenigen Teil der Quarzrohre 10, 11 nicht umgibt, der durch den Öffnungswinkel W bezeichnet ist. Dieser Öffnungswinkel W liegt vorzugsweise zwischen 10 und 90 Grad. Auch bei dieser Variante sollte darauf geachtet werden, dass der Abstand a zwischen dem äußeren Umfang des jeweiligen Stabs 8, 9 und dem anschließenden Block 42 einem Viertel der Wellenlänge der abgestrahlten Mikrowelle entspricht. Der mittlere Bereich 21 des Blocks 42 übernimmt bei diesem Ausführungsbeispiel die Funktion der Trennwand 12 in den Fig. 1 und 2.

Der Vorteil dieser Ausführungsform besteht darin, dass auch bei längeren Strukturen, d. h. Strukturen, die sich weit in die Zeichenebene hinein erstrecken, eine weitgehend homogene Verteilung des Plasmas entlang dieser Strukturen erzielt wird. Außerdem muss das durch die Einlässe 6, 7 eintretende Gas die Quarzrohre 10, 11 eng umströmen, da nur ein kleiner zylindrischer Spalt 23, 24 zwischen den Quarzrohren und dem Block 42 vorgesehen ist. Durch die Wahl der Weite der Spalten 23, 24 wird bestimmt, ob innerhalb der Spalten 23, 24 ein eng begrenztes, sehr dichtes Plasma brennt oder ob die Ausbildung des Plasmas unterdrückt wird. Im letztgenannten Fall beschränkt sich das Plasma auf den Öffnungswinkel W.

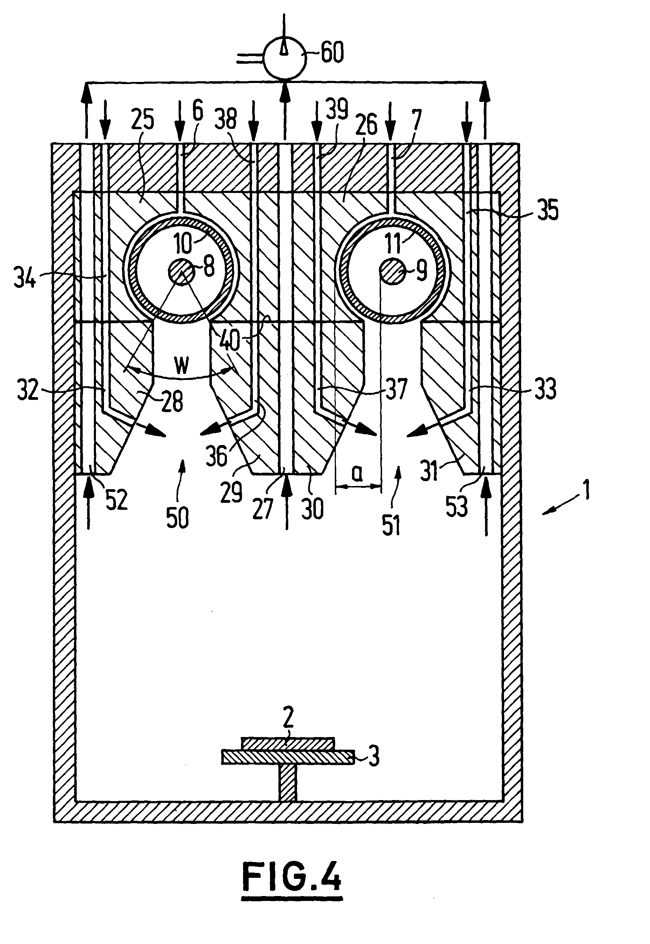

In der Fig. 4 ist eine weitere Variante der Erfindung dargestellt, die insbesondere bei der Hochratenbeschichtung von großflächigen Formteilen zur Anwendung kommt. Mit dieser Variante ist es möglich, eine gegebene Plasmaquelle an Formteile unterschiedlicher Größe und Gestalt zur Erzielung möglichst kurzzeitiger und homogener Behandlung, beispielsweise einer Beschichtung, anzupassen.

Im Unterschied zu der in Fig. 3 dargestellten Vorrichtung ist der dort einheitliche Block 42 nunmehr als zwei symmetrische Blöcke 25, 26 dargestellt, die durch eine Absaugbohrung 27 getrennt sind.

Außerdem sind an die Blöcke 25, 26 Plasma-Führungsteile 28 bis 31 angeflanscht. In den seitlichen Plasma-Führungsteilen 28 und 31 sind Gasführungskanäle 32, 33 vorgesehen, die mit entsprechenden Gasführungskanälen 34, 35 in den Blöcken 25, 26 in Verbindung stehen. Entsprechendes gilt für die Gasführungskanäle 36, 37, die den Plasma-Führungsteilen 29, 30 entsprechen, die mit entsprechenden Kanälen 38, 39 in den Blöcken 25, 26 verbunden sind. Über die Gasführungskanäle 34, 39 wird beispielsweise ein erstes Gas, über die Gasführungskanäle 6, 7 ein zweites Gas und über die Gasführungskanäle 38, 35 ein drittes Gas eingespeist.

Mit 40 ist eine Trennungslinie zwischen den Blöcken 25, 26 und den Plasma-Führungsteilen 28 bis 31 bezeichnet. Die Plasma-Führungsteile 28 bis 31 sind an dieser Trennungslinie 40 mit den Blöcken 25, 26 lösbar verbunden, etwa mittels Schrauben, die in der Fig. 4 nicht dargestellt sind. Die Absaugbohrungen 27, 52, 53 und die Gasführungskanäle 32, 33, 34, 35, 36, 37, 38, 39 müssen so ausgebildet sein, dass sich in ihnen kein Plasma ausbildet. Entscheidend hierfür ist, dass die Durchmesser von Absaugbohrung und Gaskanälen bei gegebenem Druck hinreichend klein sind.

Durch die Gasführungskanäle 32 bis 39 werden die Ausgangssubstanzen für den Plasmaprozess in die Bearbeitungskammer 1 geleitet. Hierbei bilden die Plasma-Führungsteile 28 bis 31 Düsen 50, 51 mit trichterförmiger Öffnung.

Durch Austausch der Plasma-Führungsteile 28 bis 31 kann in einfacher Weise die Verteilung und die Strahlcharakteristik der Düsen 50, 51 und somit die Einströmgeschwindigkeit der Ausgangssubstanzen in die Bearbeitungskammer 1 verändert werden.

Ist in den Blöcken 25, 26 eine hier nicht dargestellte Heizung untergebracht, so können die Plasma-Führungsteile 28 bis 31 mitgeheizt werden, da diese einen guten thermischen Kontakt zu den Blöcken 34, 35 haben. Die Aufheizung der Blöcke 25, 26 kann durch Heizspiralen, durch Heizstrahlung, durch Induktionsheizung oder auf sonstige Weise erfolgen. Das Aufheizen der Blöcke 25, 26 und damit der Plasma-Führungsteile ist bei der Einführung bestimmter Ausgangssubstanzen durch die Gasführungskanäle 34, 6, 38, 39, 7, 35 erforderlich, weil diese Substanzen auf eine bestimmte Temperatur aufgeheizt sein müssen, um die gewünschten Reaktionen im Plasmaraum zu zeigen. Mit den Absaugkanälen 27, 52, 53 und einer Pumpe 60 ist es möglich, Reaktionsprodukte aus der Bearbeitungskammer 1 nach außen zu saugen.

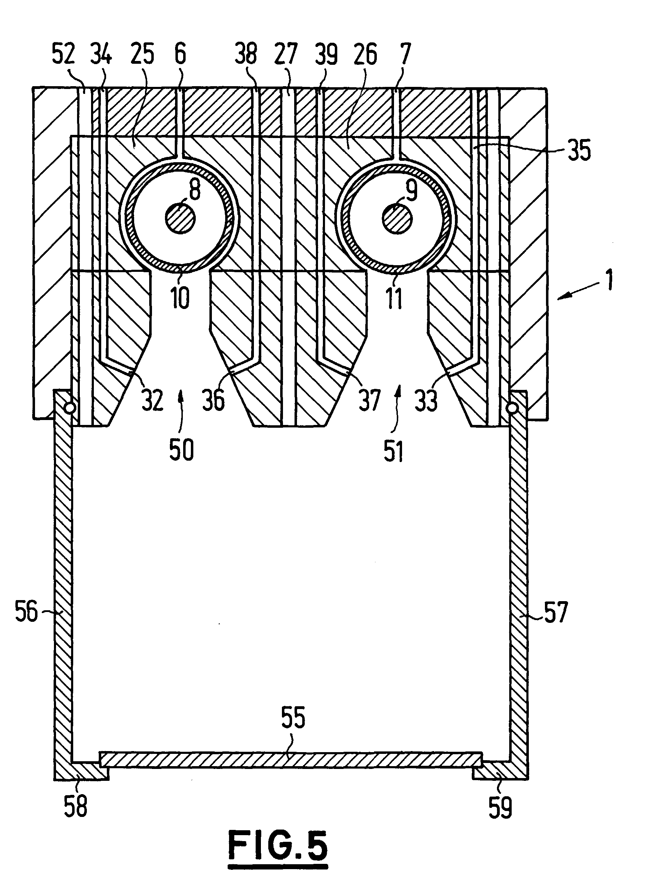

In der Fig. 5 ist eine Variante der Fig. 4 dargestellt, bei welcher die Formteile, welche das Substrat 55 bilden, von Trägern 56, 57 gehalten werden, die so ausgebildet sind, dass sie den Gasraum zwischen den Quarzrohren 10, 11 und der Oberfläche des Substrats 55 vom Rest der Bearbeitungskammer 1, die sich z. B. unterhalb des Substrats 55 bzw. rechts und links von den Trägern 56, 57 befindet, abtrennen. Hierbei weisen die Träger 56, 57 Blenden 58, 59 auf, welche das Substrat 55 tragen und außerdem nicht zu beschichtende Bereiche von Formteilen im Plasmaraum abtrennen. Diese Blenden 56 bis 59 müssen - was aus der Fig. 5 nicht hervorgeht - nicht ebenso lang wie die Quarzrohre 10, 11 sein, sondern kürzer, sodass sie nur Teile des Plasmas gegenüber dem Rest der Bearbeitungskammer ausblenden, das von den Düsen 50, 51 kommt.

Die bei den Ausführungsformen der Fig. 1 bis 5 gezeigten Stäbe 8, 9 können massiv oder auch hohl sein. Sind sie hohl, kann durch den Hohlraum eine Kühlflüssigkeit fließen.

## Patentansprüche

1. Vorrichtung zur Erzeugung eines Plasmas in einer Kammer durch Mikrowellenanregung, mit mindestens zwei in der Kammer angeordneten Mikrowellenstrahlern, **dadurch gekennzeichnet**, dass zwischen den mindestens zwei Mikrowellenstrahlern (8, 9) eine für Mikrowellen undurchlässige Sperre (12; 25, 26) vorgesehen ist.

2. Vorrichtung nach Anspruch 1, **dadurch gekennzeichnet**, dass die Sperre eine Wand (12) ist, die senkrecht auf einer gedachten Verbindungslinie zwischen den Mittelpunkten der Mikrowellenstrahler (8, 9) steht.

3. Vorrichtung nach Anspruch 1, **dadurch gekennzeichnet**, dass die Sperre ein Block (21) ist, der den größten Teil des Raums zwischen den beiden Mikrowellenstrahlern (8, 9) ausfüllt.

4. Vorrichtung nach Anspruch 1, **dadurch gekennzeichnet**, dass die Mikrowellenstrahler (8, 9) Antennen sind, die an wenigstens einen außerhalb der Kammer (1) vorgesehenen Mikrowellensender (13) angeschlossen sind.

5. Vorrichtung nach Anspruch 1, **dadurch gekennzeichnet**, dass die Mikrowellenstrahler offene Wellenleiter sind, bei denen sich wenigstens ein Teil des elektromagnetischen Feldes in die Umgebung des Wellenleiters erstreckt.

6. Vorrichtung nach Anspruch 5, **dadurch gekennzeichnet**, dass die Mikrowellenstrahler (8, 9) Eindrahtwellenleiter sind, die von jeweils einem Rohr (10, 11) umgeben sind, dessen Durchmesser wesentlich größer als der Durchmesser des Eindrahtwellenleiters ist.

7. Vorrichtung nach Anspruch 1, **dadurch gekennzeichnet**, dass die Mikrowellenstäbe (8, 9) mit einem Kühlsystem versehen sind.

8. Vorrichtung nach Anspruch 6, **dadurch gekennzeichnet**, dass das Rohr (10, 11) ein Quarzrohr ist.

9. Vorrichtung nach Anspruch 6, **dadurch gekennzeichnet**, dass die Rohre (10, 11) von einem Block (42) umgeben sind, der die Rohre (10, 11) nur in einem Teilbereich (W) freigibt.

10. Vorrichtung nach Anspruch 1, **dadurch gekennzeichnet**, dass die Sperre (12; 25, 26) aus einem elektrisch leitenden Material besteht.

11. Vorrichtung nach Anspruch 9, **dadurch gekennzeichnet**, dass der Teilbereich einem Winkel (W) zwischen 10 und 90 Grad entspricht.

12. Vorrichtung nach Anspruch 9, **dadurch gekennzeichnet**, dass der Block (42) mit Plasma-Führungsteilen (28 bis 31) verbindbar ist.

13. Vorrichtung nach Anspruch 9, **dadurch gekennzeichnet**, dass in dem Block (42) ein Heiz-System vorgesehen ist.

14. Vorrichtung nach Anspruch 1, **dadurch gekennzeichnet**, dass n Mikrowellenstrahler und n - 1 Sperren (12; 25, 26) vorgesehen sind, wobei n eine beliebige ganze Zahl gleich oder größer 2 ist.

15. Vorrichtung nach Anspruch 1, **dadurch gekennzeichnet**, dass die Sperre (12; 25, 26) an der Decke der Kammer (1) befestigt ist.

16. Vorrichtung nach Anspruch 1, **dadurch gekennzeichnet**, dass die Sperre (12; 25, 26) mit Gas-Durchtrittsöffnungen versehen ist.

17. Vorrichtung nach Anspruch 1, **dadurch gekennzeichnet**, dass der Abstand zwischen dem Mikrowellenstrahler (8, 9) und der Sperre ein Viertel der Wellenlänge der Mikrowelle beträgt.

18. Vorrichtung nach Anspruch 1, **dadurch gekennzeichnet**, dass eine Begrenzung (56 bis 59) vorgesehen ist, welche Teile des Substrats abdeckt, damit es nicht beschichtet wird.
